# EUROPEAN PATENT APPLICATION

(11) **EP 3 041 103 A1**
(43) Date of publication of application: **06.07.2016**
(21) Application number: 14200475.3
(22) Date of filing: 29.12.2014
(51) Int. Cl.: H02H 7/20, H02H 9/02, G05F 1/573

(54) **Circuit protection**

(71) Applicant: Rockwell Automation Limited, Milton Keynes Buckinghamshire MK11 3DR (GB)
(72) Inventor: AGAR, Philip J., Danbury, Essex CM3 4AJ (GB)
(74) Representative: Roberts, Peter David

(57) **Abstract**

A circuit protection apparatus comprising: a switch; a current monitor configured to monitor the current flowing through the switch; and a current limiting circuit. The current limiting circuit is arranged to control the switch so as to limit the current flowing through the switch to not exceed a predetermined non-zero threshold based upon the monitored current flowing through the switch satisfying a predetermined criterion.

## Description

The present invention relates to a circuit protection apparatus and method. More particularly, the invention relates to a current limiting switch apparatus and method of its operation.

Industrial systems are often subject to variable loading conditions. A power supply for an industrial system may be required to deliver a particular level of power for an extended period of time, for example days or months, without interruption. However, should a fault occur within the industrial system, the power supply should be able to switched off rapidly, preventing damage from occurring in the faulty system, or to any associated switching device. A switching device may, for example, become damaged if it is exposed to an overload current, preventing it from reliably performing a safety function in future operations.

In known industrial systems, a power monitor may be arranged to monitor the power supplied by a power supply, and to operate a switch in the event of any change in the monitored power which is outside an acceptable level, preventing damage to the industrial system. However, such power monitors may rely on software algorithms running on a power management controller, which may take some time to respond to any change in the monitored power. Any such delay (e.g. 1 ms) may be sufficient for damage to occur to the switch or to the industrial system as a result of a fault.

It may be desirable to provide a switching device which solves one or more problems with known switching devices, whether identified herein or otherwise. For example, it may be desirable to provide a switching device which reduces the likelihood of damage occurring to the switching device or to the industrial system when a high current level is experienced.

### BRIEF DESCRIPTION

In one aspect there is provided a circuit protection apparatus comprising: a switch; a current monitor configured to monitor the current flowing through the switch; and a current limiting circuit; wherein the current limiting circuit is arranged to control the switch so as to limit the current flowing through the switch to not exceed a predetermined non-zero threshold based upon the monitored current flowing through the switch satisfying a predetermined criterion.

In another aspect there is provided a method of protecting a circuit comprising: providing a switch; monitoring a current flowing through the switch; and controlling the switch so as to limit the current flowing through the switch to not exceed a predetermined non-zero threshold based upon the monitored current flowing through the switch satisfying a predetermined criterion.

### BRIEF DESCRIPTION OF THE DRAWINGS

Embodiments of the invention will now be described, by way of example only, with reference to the accompanying drawings in which:
Figure 1 is a schematic illustration of output module which includes a switch unit according to an embodiment of the invention;
Figure 2 is a schematic illustration of a switch unit according to an embodiment of the invention;
Figure 3 is a schematic illustration of an alternative output module which includes a switch unit according to an embodiment of the invention; and
Figure 4 is a schematic illustration of an alternative safety system which includes an output module according to an embodiment of the invention.

### DETAILED DESCRIPTION

Fault tolerant switches for use in industrial systems may be configured such that a single component failure will not cause the entire system to fail. Such switches may, for example, be configured as energise-to-action, or de-energise-to-trip switches. An energise-to-action switch may be used, for example, where a system is activated in response to some a trigger event (e.g. an airbag, or fire fighting apparatus). Alternatively, a de-energise-to-trip switch may be used where the normal operational state of the system is on, and de-energisation is in response to a trigger event (e.g. a normally open valve or a pump). In a system using either of the above switch configurations, damage may be caused if the system fails to perform a safety function on demand within a predetermined time period in response to a trigger event.

For example, where an energise-to-action switch is used, the action itself may present a hazard. A spurious activation of such a system could cause harm. For example, an airbag firing mechanism, if energised accidentally, may cause a car to crash. As such, a firing mechanism for an airbag may be provided with a fault tolerant energise-to-action switch, i.e. one which would not cause activation of the system due to a fault condition or power failure. A further example of a system in which a fault tolerant energised-to-action switch may be used is in halogen fire fighting apparatus. The release of halogen compounds (e.g. carbon tetrachloride) can douse a fire, with a vapour of the halogen compound forming and settling over the fire effectively smothering it. However, such vapours are both toxic and corrosive, and so should not be released unless fire damage is imminent and would have severe consequences. An energise-to-action switch having a fault-tolerant design will allow a single switch fault to occur, while still performing the designed safety function. For example, by using redundant parallel switches, if one of the switches was to fail (i.e. fail in a de-energised state), the second switch would still be able to provide a safety function by switching the system on.

A switch fault within a de-energise-to-trip switch may cause damage in a variety of ways. For example, a solenoid operated valve which is normally open (i.e. with the solenoid energised), and which should close upon the detection of an unsafe condition, could cause damage if the valve were to remain open after the unsafe condition was detected. Alternatively, a pump which is usually powered, and which should shut down upon the detection of an unsafe condition, may cause damage to itself or other system components if left to run once the unsafe condition is detected. Therefore, the switch should be de-energised upon the detection of an unsafe condition. A de-energise-to-trip switch having a fault-tolerant design will allow a single switch fault to occur, while still performing the designed safety function. For example, by using redundant series switches, if one of the switches was to fail (i.e. fail in an energised state), the second switch would still be able to provide a safety function by switching the system off.

It will thus be appreciated that a switch should be configured so as to remain operational in the event of a fault occurring, while also being protected from damage as a result of any such fault. Furthermore, a switch which is usually on (i.e. de-energise to trip) or usually off (i.e. energise to action) may be configured so as to be able to be tested without triggering the event the switch is arranged to cause in the event of it being energised or de-energised.

Further still, in normal operation a switch may be exposed to instantaneous currents which, if persistent, would cause damage, but which may be non-damaging for short periods of time. Such a large instantaneous current may not trigger an event to occur immediately, but instead may be arranged to cause an event should the high current persist for an extended period of time.

However, where a switch is exposed to an extreme current, such as that caused by a short-circuit within an industrial system (i.e. a current which is larger than an expected peak instantaneous inrush current), the switch may suffer damage within an extremely short period of time. Such exposure could subsequently prevent the switch from reliably performing a safety function. A switch which is exposed to such an extreme current may thus be considered more likely to fail to perform a safety function (i.e. less reliable) than a switch which is protected from any such extreme current exposure, for example by a fuse.

The response of a switch to current levels in excess of normal operational levels may thus be arranged to vary depending on the magnitude of the current above a normal level and the duration for which such a current flows.

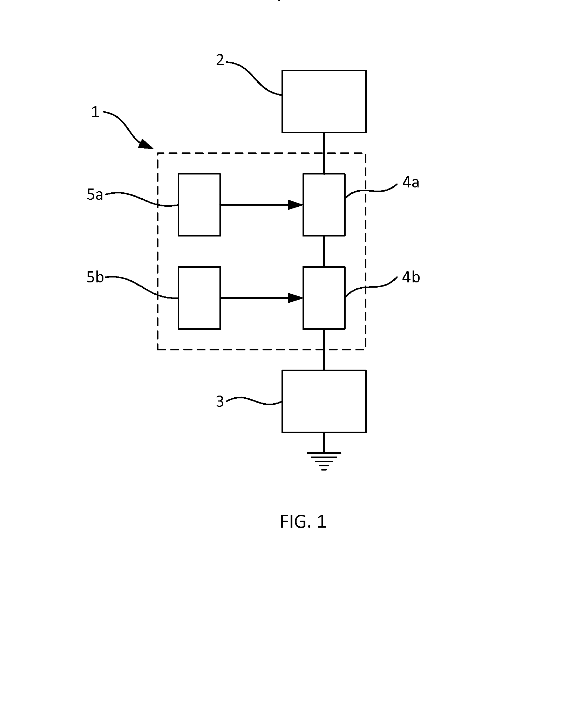

Figure 1 shows an output module 1 which forms part of an industrial system. The output module 1 is arranged to connect a field voltage, which is supplied by a field voltage power supply 2, to a load 3. The output module 1 comprises two switch units 4a, 4b, which are connected in series between the field voltage power supply 2 and the load 3. Each of the switch units 4a, 4b is controlled by a respective switch control unit 5a, 5b. The switch units 4a, 4b are examples of a circuit protection apparatus.

The configuration shown in Figure 1 is of a fault tolerant de-energise-to-trip switch. The two switch units 4a, 4b are connected in series such that should a first one of the switch units 4a, 4b develop a fault which means that the switch cannot be opened, then the second switch unit 4a, 4b can be operated to disconnect the load 3 from the field voltage power supply 2. This provides a degree of fault tolerance in that a single faulty switch unit would not prevent the output module 1 from carrying out its safety function.

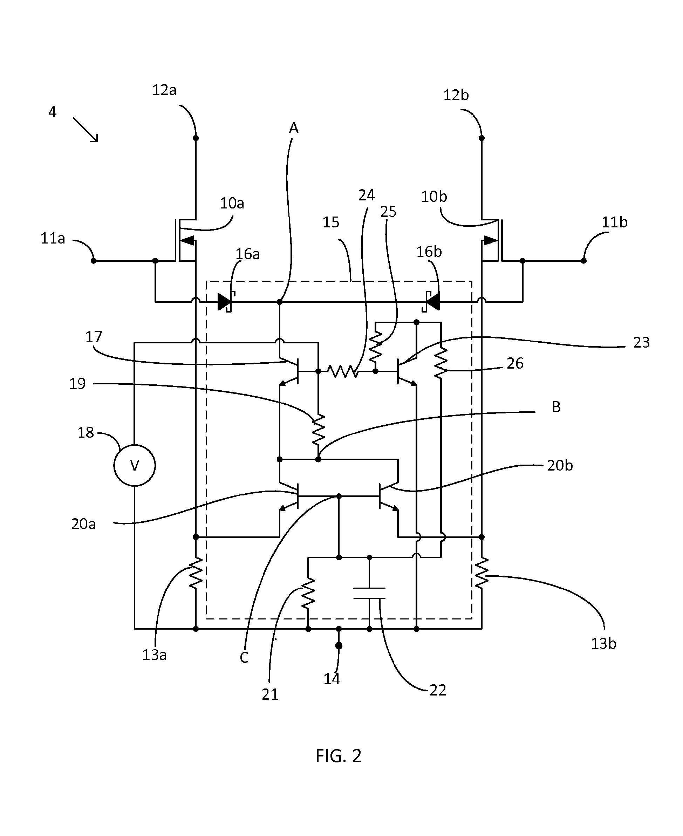

Figure 2 shows a switch unit 4 (i.e. one of the switch units 4a, 4b) in more detail. The switch unit 4 comprises a pair of field effect transistors (FETs) 10a, 10b, each having gate, source and drain terminals. The gate terminals of each of the FETs 10a, 10b are connected to a respective gate control input 11 a, 11 b. The drain terminals of the FETs 10a, 10b, are each connected to a respective field power terminal 12a, 12b. The source terminals of the FETs 10a, 10b are each connected, via a respective sense resistor 13a, 13b to a common terminal 14.

The FETs 10a, 10b are arranged to control the connection between the field power terminals 12a and 12b, via the common terminal 14. For example, if the FET 10a is turned on the field power terminal 12a will be connected by the FET 10a and the sense resistor 13a to the common terminal 14. If the FET 10a is turned off, then no forward current can flow into the field power terminal 12a. That is, if the field power terminal 12a is at a higher voltage than the field power terminal 12b, no current can flow from the field power terminal 12a to the field power terminal 12b, due to the FET 10a being turned off. The field power terminal 12b, FET 10b and sense resistor 13b are arranged in a similar way, with the FET 10b controlling the connection between the field terminal 12b and the common terminal 14. A connection between the field terminals 12a and 12b, via the common terminal 14, is thus controlled by the FETs 10a and 10b. For a connection to be made between the field power terminals 12a and 12b, then both of the FETs 10a, 10b must be on.

The common terminal 14, and gate control inputs 11 a, 11 b (which may be controlled by a switch control unit 5) are galvanically isolated from other regions of the apparatus, so as to facilitate fault tolerance. For example, where multiple redundant switch units are provided, galvanic isolation between different ones of the switch units may prevent a fault in one switch unit from affecting other ones of the switch units. In particular, in the absence of galvanic isolation, a fault in one switch unit could result in current flowing through the faulty switch unit to other switch units by a path other than that which was intended (i.e. other than between field terminals 12a and 12b), causing possible failure of the function of the output module. Galvanic isolation, on the other hand, allows for independence between redundant switches within an output module.

The components within the switch unit 4 are selected in accordance with the particular requirements of an industrial system. For example, where high voltages are required to be blocked by the FETs 10a, 10b, then devices with high drain-source voltage blocking characteristics are selected. The FETs may be N-channel high voltage MOSFETs. Each of the FETs 10a, 10b may, for example, be a FCB20N60 N-Channel SuperFET MOSFET, as manufactured by Fairchild Semiconductor. Alternatively, the FETs 10a, 10b may be other FET devices with characteristics appropriate for the power supply and load configuration.

It will be appreciated that where the FETs 10a, 10b are MOSFETs, the FETs 10a, 10b will contain body diodes. Such body diodes allow current to flow through the FETs 10a, 10b, in one direction even when turned off. In particular, where a reverse bias is applied between the drain and source terminals of the FETs 10a, 10b (i.e. a lower voltage at the drain terminal than at the source terminal) a current will flow through the body diode from the source terminal to the drain terminal. As such, a single FET 10a would be unsuitable for use as an AC switch. The use of two FETs in the arrangement shown in Figure 2, having a common source connection, allows switching of AC voltage to be effected (i.e. with no need to observe a specific connection polarity).

The gate terminals of each of the FETs 10a, 10b are also connected to a current limiting circuit 15, shown enclosed by a dashed line.

The current limiting circuit 15 comprises two diodes 16a, 16b, each having an anode and a cathode. The diodes 16a, 16b are each connected to the gate terminal of a respective one of the FETs 10a, 10b, and to a node A. The diodes 16a, 16b are arranged so as to allow conduction in a forward direction from the gate of the FETs 10a, 10b to the node A when forward biased (i.e. when the potential at the node A is lower than the potential at the gate terminal of the respective FET 10a, 10b). That is, the anode of the diode 16a is connected to the gate of the FET 10a, and the cathode is connected to the node A. The diode 16b is similarly connected, with the anode connected to the gate of the FET 10b, and the cathode connected to the node A.

The node A is connected, via a network of transistors and resistors, to the common terminal 14. The network of transistors comprises a first bipolar junction transistor (BJT) 17. The BJT 17 is an NPN BJT, having base, collector and emitter terminals. The collector terminal of the BJT 17 is coupled to the node A. The base terminal of the BJT 17 is connected to a power supply potential 18. The emitter terminal of the BJT 17 is connected to a node B. A biasing resistor 19 is also connected between the power supply potential 18 and the node B.

Two further BJTs 20a, 20b are connected in a mirror formation with their base terminals connected to one another, at a node C. The collector terminals of the BJTs 20a, 20b are also connected to one another, and to the node B. Each of the emitter terminals of the BJTs 20a, 20b is connected to a respective one of the sense resistors 13a, 13b, between the sense resistors 13a, 13b and the FETs 10a, 10b.

The node C is connected to the common terminal 14 by the parallel combination of a resistor 21 and a capacitor 22.

A temperature compensation BJT 23 is also provided within the current limiting circuit 15. The temperature compensation BJT 23 is arranged such that the base terminal is connected, via a resistor 24, to the power supply potential 18. The collector terminal of the BJT 23 is connected to the base terminal of the BJT 23 via a resistor 25, and to the node C via a resistor 26. The emitter terminal of the BJT 23 is connected directly to the common terminal 14.

The component values for each of the resistors 13a, 13b, 19, 21, 24, 25, 26, and the capacitor 22 which provide suitable biasing conditions, and a circuit which operates as further described below with reference to Figure 2, are as follows:

| **Component** | **Value** | **Unit** |
|---|---|---|
| Sense resistor 13a | 0.01 | Ω |
| Sense resistor 13b | 0.01 | Ω |
| Resistor 19 | 499 | Ω |
| Resistor 21 | 2000 | Ω |
| Resistor 24 | 4990 | Ω |
| Resistor 25 | 150 | Ω |
| Resistor 26 | 120 | Ω |
| Capacitor 22 | 100 | nF |

The above mentioned component values are calculated to work well in a circuit where the BJTs (17, 20a, 20b, 23) are each MMDT2222A transistors, as manufactured by Diodes Incorporated. The diodes 16a, 16b are BAT54 Schottky diodes, as manufactured by Fairchild Semiconductor.

The above mentioned component values are calculated to provide a circuit which performs in a stable manner when operated in conjunction with a wide variety of load characteristics. For example, the load 3 may have an impedance which is highly capacitive, or highly inductive. The switch unit 4, and in particular the current limiting circuit 15, is thus arranged to be operate in a stable manner with both capacitive and inductive loads. Significant oscillations (e.g. caused by instability) in the current flowing through the switch unit may lead to excessive energy being dissipated by the switching device, and damage being caused. Therefore, the current limiting behaviour of the switch unit 4, as controlled by the current limiting circuit 15, is controlled so as to reduce any such oscillation. Stable operation of the switch unit 4 reduces any such risk of oscillation and consequent damage.

The power supply potential 18 may supply a voltage of 3.3 V relative to the common terminal 14. The gate control inputs 11 a, 11 b may be driven at a potential of around 10 V to drive the FETs 10a, 10b into an on state. The field voltage applied between the field power terminals 12a, 12b and blocked by the FETs 10a, 10b when they are configured in an off state may be 200 V.

The current limiting circuit 15 is arranged to monitor the current flowing through the FETs 10a, 10b when the FETs 10a, 10b are on. In the event that the forward current flowing through at least one of the FETs 10a, 10b exceeds a predetermined threshold the current limiting circuit 15 is arranged to limit the current to an acceptable safe level. In such an event, the current flowing through the FETs is controlled extremely quickly, in order to prevent damage from occurring due to a fault condition. For example, the FETs themselves may be damaged by carrying an excessive current, even for a short period of time. This operation is described in more detail below.

The current flowing through the FETs 10a, 10b is substantially the same as the current flowing through respective ones of the sense resistors 13a, 13b. The current flowing through the FETs 10a, 10b and the sense resistors 13a, 13b can thus be monitored by monitoring the voltage which is developed across the sense resistors. The voltage developed will depend on the current according to Ohm's law (i.e. with a constant of proportionality defined by the resistance value of the resistor).

A large resistance value would cause a large voltage drop to be developed, and a significant amount of power to be dissipated as heat within the resistors. A large voltage drop across the resistor may also affect to operation of the circuit (e.g. by reducing the voltage drop across other circuit components). Therefore, a small value resistor may be chosen to allow a small (but detectable) voltage to be developed without materially affecting the operation of the circuit, and without causing a significant amount of power to be dissipated. A resistance value of 0.01 ohms may be selected for the sense resistors 13a, 13b.

The sense resistors 13a, 13b may be four terminal resistors. The use of a four terminal configuration enables current to flow through two opposite terminals and a sensing voltage to be measured across the other two terminals. Such a configuration reduces the effect of the resistance and the temperature coefficient of the terminals on the measurement, providing for a more accurate current measurement (especially for low value resistances).

The safe current level in an industrial system will depend upon the various properties of that system. For example, in an industrial control system an AC field voltage of 200 V may be applied to a load which draws a constant current of 1 A_{RMS} in steady state conditions. However, such a load may draw a maximum instantaneous inrush current of 10 A_{RMS}, which may flow for around 2 full cycles when a load is initially connected (i.e. the in-rush current may flow for around 40 milliseconds when the power supply frequency is 50 Hz). It will be appreciated that a 10 A_{RMS} current having a sinusoidal waveform would generate a peak current of around 14 A. Such currents are considered normal, and should be allowed to flow within a switch unit 4 without triggering any fault condition, or current limiting behaviour. A current threshold may, for example, be set at around 17 A in order to accommodate the above described load. This would provide a degree of tolerance over the expected 14 A peak current. The threshold current should also be below the maximum current allowed by the FETs 10a, 10b. For example the FCB20N60 FET is capable of allowing a continuous current of 20 A, or a pulsed (i.e. instantaneous) current of up to 60 A. If required, alternative switches may be selected.

When the FETs 10a, 10b are driven so as to be in an on state, and an excessive current is detected by the current limiting circuit 15, the gate terminals of the FETs 10a, 10b are rapidly connected to the common terminal 14, via the network of transistors and resistors within the current limiting circuit 15. This effectively controls the FETs 10a, 10b to limit the current which can flow through them (although it does not switch them to an off state). This control should be sufficiently fast to prevent the current flowing through either of the FETs 10a, 10b from exceeding the maximum short-term current allowed by those devices, preventing any damage from occurring within the FETs 10a, 10b.

When the FETs 10a, 10b are 'on', the gate terminals are driven to a predetermined voltage by a respective switch control unit 5. The predetermined voltage may, for example, be 10 volts. The switch control unit 5 may comprise, or be controlled by, a power management controller. The output of the switch control unit 5 may, for example, be driven by an operational amplifier (op-amp) which is capable of driving the gate of the FETs 10a, 10b to the predetermined voltage level.

To control the FETs 10a, 10b, the current limiting circuit 15 removes charge from the gate of the FETs 10a, 10b, and also sinks current provided by the output of the switch control unit 5. The connection of the gate terminals of the FETs 10a, 10b to the common terminal will 'pull-down' the output voltage of the switch control unit 5 to a FET gate voltage level which corresponds to a safe current level within the FETs 10a, 10b. The gate voltage is thus reduced so as to reduce the conductance of the conducting channel between the drain and source. The output of the switch control unit 5 will continue to be driven in an on state until the power management controller controls the switch control unit 5 to drive the output to an off state. As described above, this can take of the order of 1 millisecond. The current limiting circuit 15 should therefore be capable of initially sinking a large current for a short period of time (i.e. so as to remove the charge from the gate of the FETs 10a, 10b). The current limiting circuit 15 should also be capable of sinking more current than can be output by the switch control unit 5, for a time period of up to around 1 millisecond (i.e. until the power management controller controls the switch control unit 5 to drive the output to an off state). The current limiting circuit 15 may, for example, be required to sink a current of around 0.5 amps for an initial period, such as, for example, less than 1 microsecond. The current limiting circuit 15 may further be required to sink a current of, for example, around 10 mA for a longer time period, such as, for example, around 1 millisecond.

Moreover, even if the power management controller was able to detect the excessive current, and to switch the switch control unit 5 into an off state in a short time period (e.g. of the order of a few microseconds), then the FETs' gate charge would still have to be removed from the gate of the FETs 10a, 10b in order to deactivate the FETs 10a, 10b. This charge removal would take a considerable time using op-amps which may be used within switch control unit 5 to drive the gate terminal of the FETs 10a, 10b.

The industrial system is protected from damage from a current surge in a number of ways. On an extremely short time scale (e.g. < 1 microsecond), any large current will be prevented from flowing due to the parasitic wiring inductance within the system. For example, a length of wiring of around 1 metre, consisting of a pair of wires separated by 5 mm, each wire having a cross-section of 0.5 mm², may have an inductance of around 1 µH. Such an inductance value, limits the maximum rate at which the current within the wires (and therefore the industrial system) can increase in the event of an error (e.g. a short circuit within a load). Thus, in the event of a short-circuit within a load, the parasitic wiring inductance prevents current rising within the FETs 10a, 10b to a dangerous level before the current limiting circuit 15 can take effect (as described in detail above). It will be appreciated that effect of any wiring inductance will depend on the physical arrangement of the particular system. As such, the time period associated with the wiring inductance may be greater than 1 microsecond.

On a longer time scale (e.g. of the order of milliseconds) the power management controller is arranged to protect the industrial system. The power management controller monitors the voltage across the FETs 10a, 10b. If a large voltage is detected across the FETs 10a 10b, when the switch control unit 5 is driving them into an on state (i.e. a state in which there should be a minimal voltage drop across the FETs 10a, 10b) then a persistent fault condition is considered to be present. A voltage in excess of 3 V detected across the FETs 10a, 10b, may, for example, be determined to indicate that the switch unit 4 is operating in a current limiting mode. For example, if an instantaneous current surge causes the current limiting circuit 15 to pull-down the gate voltage of the FETs 10a, 10b, then a voltage drop will develop across the FETs 10a, 10b. If the current surge persists, however, then the power management controller will detect that the surge is still present, and will control the switch control unit 5 to turn the FETs 10a, 10b to an off state, preventing any damage from occurring. The response time of the power management controller is arranged to protect the FETs 10a, 10b. Thus, the power management controller controls the circuit to limit the power dissipated within the FETs 10a, 10b to within the limits recommended by the manufacturer of those devices. For example, for a device such as the FCB20N60, operating at a voltage of 200 V, a large current (e.g. 20 A) may be tolerated for between 100 microseconds and 1 millisecond (i.e. the power management controller response time may be between 100 microseconds and 1 millisecond).

The power management controller having such a response time (e.g. between 100 microseconds and 1 millisecond) may be implemented using a relatively cheap microcontroller. A more rapid response would require a more exotic microcontroller, which would be more expensive. The current limiting circuit 15 described herein reduces the need for such expensive microcontrollers by providing a rapid current-limiting response to high current levels.

The power management controller is further arranged to independently monitor the current supplied to the switch unit 4, in order to protect circuit elements from overheating. It will be appreciated that currents which may not be sufficiently high to cause the circuit to enter a current limiting mode may nevertheless cause damage to the FETs 10a, 10b (or other circuit elements) if they persist for an extended duration of time. However, the FETs 10a, 10b may be operated at current levels consistent with anticipated inrush current surges normally associated with inductive loads (e.g. AC driven solenoid loads) for significantly longer than would be permitted for larger currents (such as those caused by a short-circuit).

A power shut-down will be instigated by the power management controller if circuit elements within the switch unit 4 are deemed to be at risk of exceeding their power ratings. The response time for such a shut-down may, for example, be around 40 milliseconds or greater (i.e. 2 full cycles at 50Hz). The longer timescales associated with this mode of shutdown allow the power management controller to apply more subtle rules (e.g. rules based on combinations of current, voltage and duration) which take longer to calculate without fear of compromising the protection of the FETs. In this way, the switch unit 4 can be controlled to deliver the required inrush current without spuriously tripping.

The current limiting circuit 15 generally operates on a time scale which complements those described above (i.e. it limits the current before the effect of the parasitic inductance has entirely worn off, and does so more quickly than the response time of the power management controller). The current limiting circuit 15 takes effect within a period of time after the detection of a current flowing which is in excess of the safe threshold current. This period of time may be referred to as the current limiting time period. Further, the current limiting time period is generally less than the power management controller response time. The current limiting circuit may thus operate to limit the current flowing to a safe level (i.e. below the absolute maximum rating of the FETs 10a, 10b), for example, in less than 100 microseconds when an excessive current is detected. As described above, the power management controller may be operable to respond to excessive current levels on a timescale of between 100 microseconds and 1 millisecond. As such, the current limiting circuit 15 operates more quickly than the power management controller.

The current limiting time period may be referred to as a first predetermined time period. The power management controller response time may be referred to as a second predetermined time period.

More particularly, the current limiting circuit may operate to limit the current flowing to a safe level in less than about 10 microseconds. More particularly still, the current limiting circuit may operate to limit the current flowing to a safe level in less than or equal to about 1 microsecond. As described above, current fluctuations on a timescale shorter than 1 microsecond may be prevented by the parasitic wiring of the system.

It will be appreciated that the minimum response time of the current limiting circuit may be varied in dependence on the parasitic wiring inductance of a particular system. Further, if the excessive current is caused by a persistent system fault, then the power management controller will subsequently switch off the system. However, as this may not operate quickly enough to prevent damage from occurring, the described current limiting circuit 15 can advantageously provide protection with a faster response time.

In general, current surges may damage a switch in a relatively short period of time if not acted upon. As such, the current limiting circuit 15 is configured to respond quickly (e.g. in less than a microsecond) to current surges within the FETs 10a, 10b, so as to prevent any damage to the FETs 10a, 10b, and thus the safety integrity of switch unit 4.

The current path for sinking the current output by the switch control unit 5 to control the FET 10a is via the diode 16a to the node A, then via the BJT 17 to the node B and via either one of the BJTs 20a, 20b (and via a respective one of the sense resistors 13a, 13b) to the common terminal 14. The current path for sinking the current output by the switch control unit 5 to control the FET 10b is similar to that for the FET 10a, although making use of the diode 16b to reach the node A. Thereafter the current path is identical for the gates of both of the FETs 10a, 10b.

As described above, the diodes 16a, 16b form part of the current path through which current flows from the gates of the FETs 10a, 10b in the event of an excess current being detected flowing through the FETs 10a, 10b. The diodes 16a, 16b should therefore be able to carry at least the current output by the switch control unit 5. The diodes 16a, 16b should also be capable of switching from an off state to an on state sufficiently quickly in order to cause the FETs 10a, 10b to respond (i.e. to switch into a constant current mode) in the required time period (e.g. of the order of micro-seconds). The diodes 16a, 16b, may be Schottky diodes. The use of Schottky diodes allows a rapid switching action. As described above, the BAT54 Schottky diode, as manufactured by Fairchild Semiconductor is an example of a suitable diode.

The base terminal of the BJT 17 is connected to the power supply potential 18 (which is configured to supply (or source) as much current as is required to maintain the power supply potential at a predetermined potential). The base terminals of the BJTs 20a, 20b are biased via a network of resistors. These resistors will limit the current which can be supplied to the base terminals of the BJTs 20a, 20b. However, the capacitor 22 provides a short term current source, such that when the BJTs 20a, 20b are conducting (i.e. sinking a large current between the node B and the common terminal 14), the capacitor 22 can supply the current which is drawn by the base terminals of the BJTs 20a, 20b in order to maintain the BJTs 20a, 20b in the correct bias conditions. This is described in more detail below.

The BJTs 20a, 20b act as the current monitors which are responsible for the current limiting behaviour of the current limiting circuit. The BJTs 20a, 20b are biased such that a small change in the bias conditions will bring about a large change in the conductance between the collector and emitter of the BJT. The base terminals of the BJTs 20a, 20b (which are both connected to the node C) are biased at a stable voltage with respect to the common terminal 14. However, the emitter terminals of each of the BJTs 20a, 20b are connected to a respective one of the sense resistors 13a, 13b. This connection results in any change in the voltage across the sense resistors 13a, 13b causing the voltage across the base-emitter junctions within the BJTs 20a, 20b to be changed. In this way, the current flow through the FETs 10a, 10b will alter the conductance of the BJTs.

For example, if a large current flows from the field power terminal 12a to the field power terminal 12b then a positive voltage (with respect to the common terminal 14) is developed across the sense resistor 13a, and a negative voltage (with respect to the common terminal 14) is developed across the sense resistor 13b. The positive voltage across the sense resistor 13a causes the voltage across the base-emitter junction of the BJT 20a to be reduced. Conversely, the negative voltage across the sense resistor 13b causes the voltage across the base-emitter junction of the BJT 20b to be increased. This increase in the voltage across the base-emitter junction of the BJT 20b causes the transistor to become more conducting between the collector and the emitter. This increase in conduction between the collector and the emitter of the BJT 20b allows current to flow from the node B to the common terminal 14. The increased conductance of the BJT 20b also causes the potential at the node B to be reduced, causing the base-emitter junction of the BJT 17 to be biased into a more conducting condition (the base being connected to the constant power supply potential 18), allowing current to flow from the node A to the node B. The increase in conductance of the BJT 20b therefore allows current to flow from the gate terminal of the FETs 10a, 10b, via the diodes 16a, 16b to the node A, via the BJT 17 to the node B, and via the BJT 20b to the sense resistor 13b to the common terminal 14, pulling down the voltage at the gate terminals of the FETs 10a, 10b, so as to limit the current which can flow in the FETs 10a, 10b.

For example, the biasing conditions described above result in the base terminals of the BJTs 20a, 20b (which are both connected to the node C) being biased at around 428 mV relative to the common terminal 14. If no current is flowing through the FETs 10a, 10b, then there will be no voltage developed across the sense resistors 13a, 13b, and consequently the base emitter junctions of each of the BJTs 20a, 20b will be forward biased by around 428 mV. However, if a significant current flows through one of the FETs 10a, 10b, then a voltage will develop across the respective sense resistor 13a, 13b. For example, if a direct-current of 17 A flows from the field power terminal 12a to the field power terminal 12b, then a voltage drop of around (17 V x 0.01 Ω = ) 170 mV is developed across each of the sense resistors 13a, 13b. Taking into account the direction of the current flow (from 12a to 12b), then a positive voltage (with respect to the common terminal 14) is developed across the sense resistor 13a, and a negative voltage (with respect to the common terminal 14) is developed across the sense resistor 13b.

A current of 14 A therefore results in the base-emitter junction of the BJT 20a being biased at (428 - 170 = ) 258 mV, and the base-emitter junction of the BJT 20b being biased at (428 + 170 = ) 598 mV.

The BJT 20a will thus be turned more on, while the BJT 20b will be turned less on. Given the common connection of the collectors of the BJTs 20a, 20b to the node B, and to the node A (via the BJT 17), turning on either one of the BJTs 20a and 20b results in the node A being coupled to the common terminal 14.

As stated above, the gate control inputs 11 a, 11 b may be driven at a voltage of around 10 V relative to the common terminal 14 when the FETs 10a, 10b are intended to be in an on state, or at a voltage of 0 V relative to the common terminal 14 when the FETs 10a, 10b are intended to be in an off state. The on state voltage is above the threshold voltage of the FETs 10a, 10b, whereas the off state voltage is below the threshold voltage of the FETs 10a, 10b. The gate control inputs 11 a, 11 b may be pulled-down to a voltage between 10 V and 0 V relative to the common terminal 14 when the FETs 10a, 10b are intended to be in a current-limited state. For example, when the current is limited to around 17 A, the voltage at the gate terminals of the FETs 10a, 10b may be around 5.5 V. The voltage at the gate terminals of the FETs 10a, 10b in the current-limited state (e.g. 5.5 V) may still be above the threshold voltage for the FETs 10a, 10b (which may be, for example, between 3V and 5V for the FCB20N60), allowing limited current to be conducted by the FETs 10a, 10b.

The operation of the current limiting circuit 15 as described above takes the form of a continuous feedback loop, rather than having distinct states. If a larger current flows within the FETs 10a, 10b a larger voltage is developed across the sense resistors 13a, 13b. This larger voltage results in one of the BJTs 20a, 20b being biased into a more 'on' state, and reduces the resistance of the current path between the gate of the FETs 10a, 10b and the common terminal 14. This reduction in the resistance of the current path causes the voltage at the gates of the FETs 10a, 10b to be reduced, which in turn reduces the conductance of the FETs, and causes less current to be allowed to flow through the FETs. It will also be appreciated that should the current flowing through the FETs reduce, the opposite process will occur, and the current will be allowed to increase (up to a safe level). In this way, the current flowing within the FETs 10a, 10b is regulated so as to not exceed a safe level.

If the direction of current was opposite to that described above (i.e. from the field power terminal 12b to the field power terminal 12a) then the operation described above simply reverses, with the BJT 20b being responsible for switching both the FETs 10a, 10b. A high current detected in either one of the sense resistors 13a, 13b therefore triggers both of the FETs 10a, 10b to be current limited simultaneously. The control of both of the FETs 10a, 10b in response to excess current in either of the sense resistors allows the switch unit 4 to be used in both DC and AC applications. DC operation (with current flowing in either direction) is described above. AC operation simply involves the current direction cycling between flowing in either direction.

The resistance value of the resistor 21 is selected to provide a bias voltage at the base terminals of the BJTs 20a, 20b.

The capacitor 22 provides a reservoir of charge at the base terminals of the BJTs 20a, 20b. As charge is removed from the gates of the FETs 10a, 10b, in response to the detection of an over-current condition, a large current (e.g. up to 0.5 amps) is caused to flow through the current limiting circuit 15, via the BJTs 20a, 20b. This flow of current through the collector-emitter junctions of the BJTs 20a, 20b causes an increased current to be drawn by the base terminals of the BJTs 20a, 20b, the proportion being given by the gain of the BJTs 20a, 20b. The capacitor 22 thus provides a reservoir of charge to supply base current to the BJTs 20a, 20b while a significant charge is removed from the gates of the FETs 10a, 10b. Once the FETs 10a, 10b have been switched into a current limiting state (as described in detail above), the base current drawn by the BJTs 20a, 20b will be much reduced, and can be supplied by the power supply potential 18 through the resistor network of the current limiting circuit 15.

The temperature regulation BJT 23 is arranged so as to compensate the current limiting circuit 15 for any temperature fluctuations which may occur during normal operation. The BJTs 17, 20a, 20b and 23 are each similar devices, and will thus have a similar temperature response. Moreover, the BJTs 17 and 23 may be provided within a single semiconductor package, ensuring they are at a similar temperature. The voltage drop across a PN junction as is present within each of the BJTs may vary between, for example, 0.5 and 0.8 V across a temperature range of -25 °C and +70 °C. If uncompensated, such a change in voltage drop would cause significant changes to the bias conditions within the current limiting circuit 15, and would thus change the current level which was allowed to flow through the FETs 10a, 10b. However, the temperature compensation provided by the BJT 23 limits the variation in current limit as a result of temperature fluctuations to around 10-20 per cent, which may be acceptable for many applications. Such temperature effects are considered when determining a current limit level tolerance above the expected maximum instantaneous current for a particular industrial system.

In general, a switch unit according to embodiments of the invention provides protection to the switch in the event that excess current is drawn by a load connected to the switch unit. While a simple fuse might allow a system to be protected from excess current flow, the requirement of such a fuse to be replaced once a fault has been repaired could be inconvenient, especially where a system is remote or inaccessible. Further, the use of a current limiting switch may also be configured to be less sensitive to variations in temperature than would be the case for a conventional fuse, which may exhibit a significant variation in switching performance at different temperatures.

Systems using switch units of the type described above are generally used to provide safety functions. Such systems may provide safety integrity, which arises through being fault tolerant in respect of the safety function. That is, a system with safety integrity can continue to perform a safety function in spite of some component fault. Such systems may additionally or alternatively provide availability, which arises through being fault tolerant in respect of the avoiding spurious activations of the safety function. That is, a system with availability can continue to operate even if a device has been spuriously activated (e.g. by a fault), allowing continued availability of the safety function.

The system described above with reference to Figure 1 offers safety integrity for a de-energise to trip safety function (i.e. only one of the switch units 4a, 4b needs to be operational to de-energise a connected load). However, the system of Figure 1 does not provide any availability should one of the switch units 4a, 4b be spuriously activated.

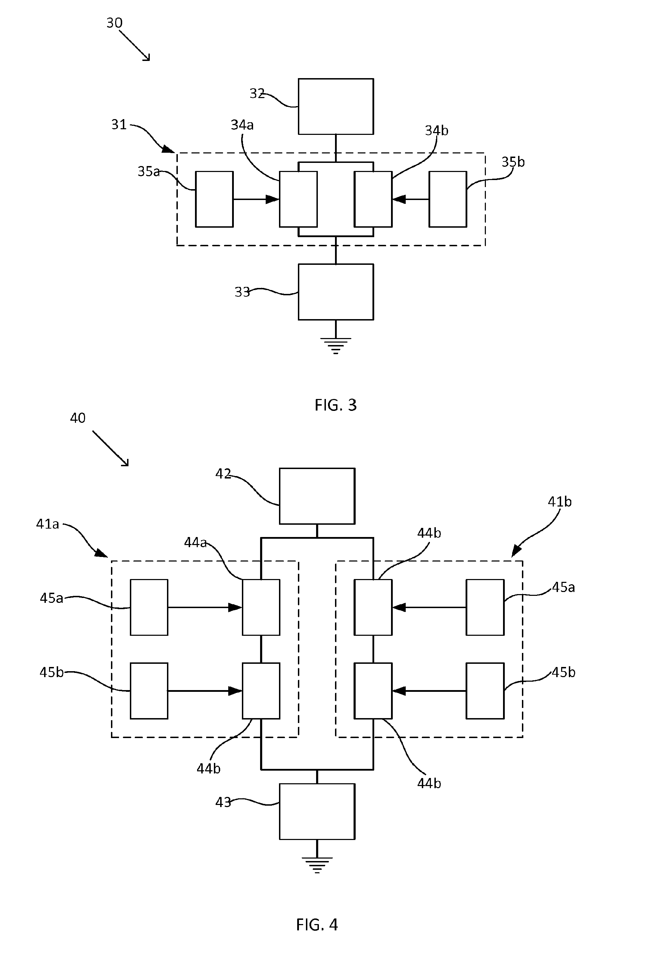

It will be appreciated that in addition to arrangement shown in Figure 1, a switch unit according to embodiments of the invention may be used in alternative arrangements. For example, Figure 3 shows an alternatively configured safety system 30 comprising an output module 31. The output module 31 is arranged to connect a field voltage, which is supplied by a field voltage power supply 32, to a load 33. The output module 31 comprises two switch units 34a, 34b, each of which are examples of a switch unit 4. The switch units 34a, 34b connected in parallel between the field voltage power supply 32 and the load 33. Each of the switch units 34a, 34b is controlled by a respective switch control unit 35a, 35b.

The configuration shown in Figure 3 is of a fault tolerant energised-to-action switch. The two switch units 34a, 34b are connected in parallel such that should a first one of the switch units 34a, 34b develop a fault which means that the switch cannot be closed, then the second switch unit 34a, 34b can be operated to connect the load 33 to the field voltage power supply 32. This provides a degree of fault tolerance in that should a single switch unit fail this would not cause total failure of the output module 31. Thus, in contrast to the system shown in Figure 1, the system of Figure 3 offers safety integrity for an energised-to-action safety function (i.e. only one of the switch units 4a, 4b needs to be operational to energise a load on demand). However, the system of Figure 3 does not provide any availability should one of the switch units 4a, 4b be spuriously activated.

In addition to the configurations of the output modules 1, 31 described with reference to Figure 1 and 3 respectively, alternative configurations are possible. For example, a single switch unit 4 may be used in an output module. Alternatively, or in addition, several output modules may be combined, providing both redundancy and short-circuit protection simultaneously.

The use of multiple switches in series, as described with reference to the output module shown in Figure 1, provides a degree of safety integrity. That is, should a single switch unit (e.g. switch unit 4a) fail, the output module 1 described would still be able to provide the intended safety function by the use of a second (redundant) switch (e.g. switch unit 4b). However, such an arrangement may be susceptible to spurious activation should a switch unit fail in an off state. That is, should a switch unit fail in an open condition, no power would be supplied to the load 3. While this failure condition may be safe, it may well cause significant inconvenience. Therefore, in order to provide fault tolerance in addition to safety integrity, additional output modules may be provided in parallel,

For example, Figure 4 shows an embodiment in which a safety system 40 comprises two output modules 41 a, 41 b arranged in parallel. The output modules 41 a, 41 b connect a field voltage, which is supplied by a field voltage power supply 42, to a load 43. Each of the output modules 41 a, 41 b comprises two switch units 44a, 44b, each of which are examples of a switch unit 4. The switch units 44a, 44b are connected in series between the field voltage power supply 42 and the load 43. Each of the switch units 44a, 44b is controlled by a respective switch control unit 45a, 45b. The safety system 40 thus provides fault tolerance with respect to safety integrity and availability by providing both series and parallel redundancy. By connecting two output modules in parallel, either one of the modules can be temporarily removed without affecting the process being controlled (save for a temporary reduction in fault tolerance).

It will be appreciated that various modifications to the embodiments of the invention described above can be made without departing from the spirit and scope of the invention.

The component values provided are solely for the purposes of illustration, and are not intended to limit the scope of protection sought. It will be appreciated by one skilled in the art that the arrangement and selection of components described above is an appropriate arrangement and selection for the described application (i.e. a 200 V supply, in combination with a load requiring a steady current of 1 A and a maximum instantaneous in-rush current of 10 A). As such, modifications can be made to the described embodiments in order to accommodate any modifications of the intended application. The person skilled in the art may, for example, use standard circuit analysis or simulation techniques in order to calculate new component values when a particular circuit requirement is altered from those described above.

In an embodiment, the current limiting circuitry may be provided separately from the switch and switch control circuitry. In such an arrangement, the current limiting circuitry may be coupled to a gate control input of a switch, having a separate current monitoring input which monitors the current flowing in the switch. In general, embodiments of the invention are intended to maintain a system within a safe operating limits while a power management controller can effect a longer term safety response. Therefore, provided electrical wiring does not introduce response delays which would prevent a timely (and safe) response, there is no requirement for proximity between the switch and switch control circuitry.

In an embodiment, a switch unit may be provided with a single FET. This may be used in a DC application where the current direction does not reverse.

In an embodiment, switches other than FETs may be used. Alternative switching devices may be selected based upon the requirements of a particular application. For example, any switching device capable of switching off sufficiently quickly in the presence of a short-circuit load to avoid causing damage to a power supply, or blowing a circuit fuse may be used.

In an embodiment, where temperature regulation is not considered to be an important consideration (for example where the operational temperature of a system is well controlled), the temperature compensation BJT 23 could be removed from the circuit described with reference to Figure 2. If such a change was made, other components, such as, for example, resistors 21, 24, 25 and 26 should be modified accordingly. In particular resistors 25 and 26 would be replaced by simple links, while the resistance values of resistors 21 and 24 would be changed to ensure the circuit was correctly biased.

In general, where the terms connect or connected are used to describe the configuration of a circuit component, a direct connection is not required. For example two nodes within a circuit could be connected by a resistor, or by a plurality of components, and be considered to be connected to one another. Similarly, two nodes being directly connected by a wire would also be considered to be connected.

In an embodiment there is provided a circuit protection apparatus comprising: a switch; a current monitor configured to monitor the current flowing through the switch; and a current limiting circuit; wherein the current limiting circuit is arranged to control the switch so as to limit the current flowing through the switch to not exceed a predetermined non-zero threshold based upon the monitored current flowing through the switch satisfying a predetermined criterion.

The predetermined criterion may be the magnitude of the current exceeding the predetermined non-zero threshold.

The current limiting circuit may be arranged to limit the current within a first predetermined time period.

The first predetermined time period may be less than 100 microseconds. The first predetermined time period may be less than 10 microseconds. The first predetermined time period may be less than 1 microsecond.

The switch may be a field effect transistor.

The current limiting circuit may be configured to connect a gate terminal of the field effect transistor to a power supply potential which is around the threshold voltage of the field effect transistor based upon the monitored current satisfying the predetermined criterion.

The current limiting circuit may comprise a diode, an anode of the diode being connected to the gate terminal of the field effect transistor, and a cathode of the diode connected to a node A, and wherein the node A is switchably connected to a power supply potential which is lower than threshold voltage of the field effect transistor. The diode may be a Schottky diode.

The circuit protection apparatus may further comprise a second switch and a second current monitor configured to monitor the current flowing through the second switch.

The current limiting circuit may be arranged to control the second switch so as to limit the current flowing through the second switch to not exceed the predetermined non-zero threshold based upon the current flowing through the first switch or the second switch satisfying a predetermined criterion.

The circuit protection apparatus may further comprise temperature regulation circuitry arranged such that the predetermined non-zero threshold does not change by more than 20 per cent across a predetermined temperature range.

In an embodiment there is provided an output module comprising two circuit protection apparatus as described above connected in series.

In an embodiment there is provided a power management system comprising: a circuit protection apparatus as described above, and a power management controller arranged to control the switch so as to prevent any current from flowing through the switch based upon the monitored current flowing through the switch satisfying a second predetermined criterion within a second predetermined time period; wherein the first predetermined time period is shorter than the second predetermined time period.

In an embodiment there is provided a method of protecting a circuit comprising: providing a switch; monitoring a current flowing through the switch; and controlling the switch so as to limit the current flowing through the switch to not exceed a predetermined non-zero threshold based upon the monitored current flowing through the switch satisfying a predetermined criterion.

The predetermined criterion may be the magnitude of the current exceeding the predetermined non-zero threshold.

The method may comprise limiting the current within a first predetermined time period.

The first predetermined time period may be less than 100 microseconds. The first predetermined time period may be less than 10 microseconds. The first predetermined time period may be less than 1 microsecond.

The switch may be a field effect transistor.

The method may comprise connecting a gate terminal of the field effect transistor to a power supply potential which is around the threshold voltage of the field effect transistor based upon the monitored current satisfying the predetermined criterion.

The method may further comprise providing a diode, an anode of the diode being connected to the gate terminal of the field effect transistor, and a cathode of the diode connected to a node A, and wherein the node A is switchably connected to a power supply potential which is lower than threshold voltage of the field effect transistor. The diode may be a Schottky diode.

The method may further comprise providing a second switch, monitoring a current flowing through the second switch.

The method may further comprise controlling the second switch so as to limit the current flowing through the second switch to not exceed the predetermined non-zero threshold based upon the current flowing through the first switch or the second switch satisfying a predetermined criterion.

The method may further comprise controlling the switch such that the predetermined non-zero threshold does not change by more than 20 per cent across a predetermined temperature range.

The method may further comprise connecting two circuit protection apparatus as described above in series.

The method may further comprise controlling, by a power management controller, the switch so as to prevent any current from flowing through the switch based upon the monitored current flowing through the switch satisfying a second predetermined criterion within a second predetermined time period; wherein the first predetermined time period is shorter than the second predetermined time period.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the appended claims.

This description uses examples to disclose the invention and also to enable any person skilled in the art to practice the invention, including making and using any devices or systems and performing any incorporated methods. The patentable scope of the invention is defined by the claims and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A circuit protection apparatus comprising:
a switch;
a current monitor configured to monitor the current flowing through the switch; and
a current limiting circuit;
wherein the current limiting circuit is arranged to control the switch so as to limit the current flowing through the switch to not exceed a predetermined non-zero threshold based upon the monitored current flowing through the switch satisfying a predetermined criterion.

2. A circuit protection apparatus according to claim 1 wherein the predetermined criterion is the magnitude of the current exceeding the predetermined non-zero threshold.

3. A circuit protection apparatus according to claim 1 or claim 2 wherein the current limiting circuit is arranged to limit the current within a first predetermined time period.

4. A circuit protection apparatus according to claim 3 wherein the first predetermined time period is less than 100 microseconds.

5. A circuit protection apparatus according to claim 4 wherein the first predetermined time period is less than 10 microseconds.

6. A circuit protection apparatus according to claim 5 wherein the first predetermined time period is less than or equal to 1 microsecond.

7. A circuit protection apparatus according to any preceding claim wherein the switch is a field effect transistor.

8. A circuit protection apparatus according to claim 7 wherein the current limiting circuit is configured to connect a gate terminal of the field effect transistor to a power supply potential which is around the threshold voltage of the field effect transistor based upon the monitored current satisfying the predetermined criterion.

9. A circuit protection apparatus according to claim 8, wherein the current limiting circuit comprises a diode, an anode of the diode being connected to the gate terminal of the field effect transistor, and a cathode of the diode connected to a node A, and wherein the node A is switchably connected to a power supply potential which is lower than threshold voltage of the field effect transistor.

10. A circuit protection apparatus according to any preceding claim further comprising a second switch and a second current monitor configured to monitor the current flowing through the second switch.

11. A circuit protection apparatus according to claim 11 wherein the current limiting circuit is arranged to control the second switch so as to limit the current flowing through the second switch to not exceed the predetermined non-zero threshold based upon the current flowing through the first switch or the second switch satisfying a predetermined criterion.

12. A circuit protection apparatus according to any preceding claim further comprising temperature regulation circuitry arranged such that the predetermined non-zero threshold does not change by more than 20 per cent across a predetermined temperature range.

13. An output module comprising two circuit protection apparatus according to any preceding claim connected in series.

14. A power management system comprising:
a circuit protection apparatus according to claim 3 or any claim dependent thereon, and
a power management controller arranged to control the switch so as to prevent any current from flowing through the switch based upon the monitored current flowing through the switch satisfying a second predetermined criterion within a second predetermined time period;
wherein the first predetermined time period is shorter than the second predetermined time period.

15. A method of protecting a circuit comprising:
providing a switch;
monitoring a current flowing through the switch; and
controlling the switch so as to limit the current flowing through the switch to not exceed a predetermined non-zero threshold based upon the monitored current flowing through the switch satisfying a predetermined criterion.
